Europäisches Patentamt

European Patent Office

Office européen des brevets

(19)

(11) Veröffentlichungsnummer: **0 079 974**
**B1**

(12) **EUROPÄISCHE PATENTSCHRIFT**

(45) Veröffentlichungstag der Patentschrift:
**04.02.87**

(51) Int. Cl.⁴: **G 03 F 5/22**

(21) Anmeldenummer: **81109796.3**

(22) Anmeldetag: **20.11.81**

(54) Rastersystem für den Mehrfarbendruck.

(43) Veröffentlichungstag der Anmeldung:
**01.06.83 Patentblatt 83/22**

(45) Bekanntmachung des Hinweises auf die Patenterteilung:
**04.02.87 Patentblatt 87/6**

(84) Benannte Vertragsstaaten:
**AT BE CH DE FR GB IT LI NL SE**

(56) Entgegenhaltungen:
**DE-A-2 827 596**
**DE-C-1 901 101**
**DE-C-2 012 728**
**DE-C-2 107 738**

(73) Patentinhaber: **DR.- ING. RUDOLF HELL GmbH,
Grenzstrasse 1-5, D-2300 Kiel 14 (DE)**

(72) Erfinder: **Schoppmeyer, Johannes,
Johannesstrasse 27, D-5205 St. Augustin 3 (DE)**

**Beschreibung**

Die vorliegende Erfindung betrifft ein Rastersystem für den Mehrfarbendruck, bei dem für die einzelnen Farbauszüge jeweils Raster verwendet werden, deren Winkelung und Rasterweiten voneinander abweichen.

Beim Druck von gerasterten Farbsätzen im Mehrfarbendruck sind häufig Farbtonverschiebungen zu bemerken. Diese Farbtonverschiebungen können flächenhaft von Druckbogen zu Druckbogen auftreten. Dann sind die Ursachen Passerschwankungen von Bogen zu Bogen, die zu systematischen Veränderungen der Rasterpunktüberdeckungsverhältnisse und somit zu den Farbtonschwankungen führen. Um diese Schwankungen in Grenzen zu halten, druckt man die einzelnen gerasterten Farbauszüge nicht ungewinkelt aufeinander, sondern verwinkelt die einzelnen Raster gegeneinander.

Bei der konventionellen Rasterwinkelung sind die gleichperiodischen Raster der Farben Cyan, Magenta, Schwarz je 30° bzw. bei elliptischer Punktform je 60° gegeneinander verwinkelt und die Farbe Gelb wird mit einer Winkeldifferenz von 15° zwischen zwei andere Farben gelegt. Es wird in diesem Zusammenhang auf die DIN 16547 verwiesen. Die 60°-Winkelung ist nicht nur für elliptische Punktformen, sondern auch bei sich nicht exakt rechtwinklig schneidenden Rasterlineaturen zu empfehlen und deshalb in die vorgenannte DIN 16547 mit aufgenommen worden. Werden die einzelnen Winkelungsrichtungen nicht exakt eingehalten, tritt Moirébildung auf. Die Moiréerscheinung ist ein Überlagerungs- oder Interferenzphänomen, das sich je nach Rasterart durch streifen- oder flächenförmige Musterbildung im Druckbild bemerkbar macht. Verursacht wird das Moiré bei der konventionellen Winkelung durch die Raster der Druckfarben Cyan, Magenta und Schwarz. Bei exakter Winkelung wird der Abstand der Moiréstreifen oder -punkte - auch Moiréperiode genannt - unendlich groß, man sagt, das Moiré ist ins Unendliche ausgewinkelt. Geringe Winkelungsfehler reduzieren die Moiréperioden auf eine deutlich erkennbare Größe. Die DIN 16547 sieht eine Winkelungsgenauigkeit von $\pm 3'$ vor. Die Einhaltung dieser Winkelungsgenauigkeit bei den Verarbeitungsschritten Aufrasterung, Montage, Druckplattenkopie und Druck bereitet in der Praxis oft große Schwierigkeiten und wird daher nicht immer eingehalten. Es kommt dann zur Moirébildung, und die dadurch verursachten Farbtonschwankungen führen bei der Qualitätskontrolle zu Beanstandungen, d. h. zu schlechter Qualität.

Aber auch bei exakter Winkelung können Passerschwankungen von Druckbogen zu Druckbogen zu unterschiedlichen Überdeckungsverhältnissen der Rasterpunkte und somit zu Farbtonschwankungen von Bogen zu Bogen führen. Diese Erscheinung wird Farbspiel genannt.

Ein anderes Rasterungssystem als das konventionelle in der DIN-Norm beschriebene System ist aus der DE-B- 19 01 101 bekannt. Hierbei wird die Rasterung direkt ohne Kontaktraster mittels eines Scanners auf dem Farbauszugsfilm vorgenommen. Die praktische Ausführung dieses Rasterungssystems ist in der DE-C 20 12 728 bzw. in der DE-C 21 07 738 angegeben, wobei die Erstellung der gerasterten Farbauszüge, wie bereits erwähnt, direkt auf dem Farbauszugsfilm erfolgt.

Hierbei kommt es darauf an, daß die Winkel der einzelnen Raster einen rationalen Tangens haben. Die Verwendung von Rastersystemen mit rationalem Tangens ermöglichte zum ersten Mal, mit Trommelscannern gerasterte Farbauszüge für den Mehrfarbendruck herzustellen, was sonst nur mit der konventionellen Rasterung mittels Kontaktraster oder mit Flachbettscannern möglich war. Hierbei ging man von der Verwendung gleichperiodischer Raster für alle Winkellagen ab und führte Raster, wie bereits erwähnt, mit rationalem Tangens und unterschiedlichen Rasterfeinheiten ein. Auch bei diesem Winkelungssystem ist wieder das Moiré ins Unendliche ausgewinkelt, und ebenso führen Passerschwankungen von Bogen zu Bogen zu Farbtonschwankungen wie bei der konventionellen Winkelung.

Ein weiterer Schritt ist in der Dissertation von Dr.-Ing. Helmut Schmidt, Friedrich-Wilhelm Universität, Bonn, vom 30.4.1975, "Ein Beitrag zur mehrfarbigen Rasterreproduktion unter besonderer Berücksichtigung großformatiger Kopierraster und einer optimalen Kombination zwischen Rasterwinklung und Rasterweiten", vorgeschlagen worden. Hierbei sollen ebenfalls Raster unterschiedlicher Feinheit verwendet werden, aber durch eine Kombination von Rasterfeinheiten und Rasterwinkeln wird versucht, das Moiré nicht mehr ins Unendliche auszuwinkeln, sondern nur ein Feinmoiré zu erzeugen, das unempfindlich gegen Winkelungsfehler sein soll.

Es ist weiterhin in der DE-A- 28 27 596 vorgeschlagen worden, mittels Trommelscannern auch Rastersysteme zu verarbeiten, die keinen rationalen Tangens haben. Es hat sich aber in der Zwischenzeit gezeigt, daß zwar die in der Dissertation von Schmidt vorgeschlagenen Raster mit Hilfe von Kontaktrastern oder dieses Verfahrens gem. DE-A- 28 27 596 realisiert werden können, aber Druckversuche haben gezeigt, daß zwar innerhalb des Toleranzbereichs kein Grobmoiré auftritt, aber gleichzeitig weist das erzeugte Feinmoiré eine zu große sichtbare Struktur auf, weshalb diese Raster für die Farbbildreproduktion nicht geeignet sind. Nachteilig erweist sich außerdem, daß sich der Feinstruktur beim Vier-Farben-Übereinanderdruck noch eine quadratische Struktur mit einer Periode von ca. 1,5 mm überlagert, die ebenfalls sichtbar ist und damit störend wirkt.

Würden für den Vier-Farben-Rasterdruck im Rahmen einer manuellen, praktischen Untersuchung, um geeignete Raster zu erhalten, die Rasterperioden im Feinheitenbereich von 54 L/cm bis 80 L/cm in 0,005 mm Schritten und die Winkel $\alpha_{1,2}$, $\alpha_{2,3}$ und $\alpha_{3,4}$ zwischen den Rastern im Bereich von 10° bis 50° in 1° Schritten variiert werden, so errechnet sich die Anzahl der zu untersuchenden Kombinationen nach einfachen kombinatorischen Regeln zu 12 x 12 x 12 x 12 x 40 x 40 x 40 gleich 1.327.104.000 Möglichkeiten.

Betrachtet man den Dreifarbendruck, so errechnet sich die Anzahl auf 12 x 12 x 12 x 40 x 40 gleich 2.764.800 mögliche Kombinationen.

Hieraus ergibt sich, daß es auf diese Art und Weise nicht möglich ist, mit vertretbarem Aufwand zu

2

geeigneten Rastersystemen zu kommen, da für jede Kombination ein Versuch gemacht werden müßte.

Aufgabe der vorliegenden Erfindung ist es daher, verbesserte Rastersysteme für den Mehrfarbendruck anzugeben, die verwinklungsunanfällig sind, d. h. Systeme, die mit möglichst geringen Anforderungen an die Verwinklungsgenauigkeit auskommen, sowie Systeme anzugeben, die ein Feinmoiré mit grober Struktur vermeiden, um die von der Praxis geforderte hohe Qualität zu erreichen, und die das auftretende Farbspiel verhindern, welches ein Nachteil der bekannten Rastersysteme ist. Die Erfindung erreicht dies durch die in den Patentansprüchen 1 bis 6 angegebenen Merkmale. Vorteilhafte Weiterbildungen der Erfindungen sind in den Unteransprüchen 7 bis 12 beschrieben.

Die Erfindung wird im folgenden anhand der Fig. 1 - 4 näher erläutert. Es zeigen die

Fig. 1a und 1b die Rosettenstruktur bei konventionellen Rasterungen (Stand der Technik),

Fig. 2a und 2b die Rosettenstruktur bei elektronischer Rasterung (Stand der Technik),

Fig. 3a und 3b die Rosettenstruktur bei einem Rastersystem gemäß der Erfindung und

Fig. 4 ein Vergleichsdiagramm für die Abhängigkeit des sich aus dem Farbspiel ergebenden Farbabstandes vom Flächenbedeckungsgrad für die verschiedenen Rastersysteme.

Im folgenden wird die Erfindung näher erläutert. Die Tabelle zeigt einige Rastersysteme, welche als Beispiel zur vorliegenden Erfindung zu werten sind. Die Werte $d_1$, $d_2$ und $d_3$ geben jeweils die Rasterperiode, die als Reziprokzahl der Rasterfeinheit in Linien/cm zu verstehen ist und die Werte $\alpha_{1,2}$ und $\alpha_{2,3}$ und die Winkelung der Raster zueinander an, wobei die Indizes 1, 2 und 3 sich jeweils auf eines der 3 Druckraster im 3-Farben-Druck, bei dem mit den Farben Magenta, Cyan und Gelb gedruckt wird, beziehen.

Rasterperiode Winklung

$d_1$ $d_2$ $d_3$ $\alpha_{1,2}$ $\alpha_{2,3}$

| [mm] | [mm] | [mm] | [o] | [o] |
|------|------|------|-----|-----|
| 0,185 | 0,125 | 0,185 | 20-23 | 33-35 |
| 0,160 | 0,135 | 0,155 | 22-23 | 27-29 |
| 0,155 | 0,135 | 0,185 | 27-29 | 34-35 |
| 0,155 | 0,130 | 0,170 | 25-27 | 35-36 |
| 0,155 | 0,130 | 0,150 | 21-24 | 27-29 |
| 0,145 | 0,130 | 0,175-80 | 27-29 | 31-35 |
| 0,145 | 0,160 | 0,170 | 20-22 | 21-14 |
| 0,145 | 0,125 | 0,150 | 25-27 | 22-24 |
| 0,145 | 0,125 | 0,170 | 26-29 | 34-35 |
| 0,140 | 0,155 | 0,165 | 20-23 | 20-24 |
| 0,140 | 0,125 | 0,175 | 27-31 | 32-35 |
| 0,140 | 0,125 | 0,150 | 25-27 | 22-25 |
| 0,125 | 0,130 | 0,150 | 20-26 | 25-29 |

Wie aus der in dieser Tabelle angegebenen Auswahl zu entnehmen ist, sollen gemäß der vorliegenden Erfindung nicht beliebige Rasterwinkel verwendet werden, sondern es gelten folgende Winkelbereiche:

$\alpha = 19°$ bis $24°$

$\alpha = 25°$ bis $29°$

$\alpha = 32°$ bis $36°$

Ebenso ergibt sich aus der erfindungsgemäßen Auswahl, daß die Rasterfeinheitenkombination der Systeme durch Multiplikation der Rasterperioden mit konstantem Faktor teilweise ineinander übergeführt werden können, was insofern von Vorteil ist, als eine Kombination in eine gewünschte Rasterfeinheit umgewandelt werden kann. Im folgenden wird ein Beispiel für eine solche Umwandlung gegeben, welches in der Praxis gute Resultate gezeigt hat:

$d_1 = 0,145$ mm, $d_2 = 0,125$ mm, $d_3 = 0,150$ mm, $\alpha_{1,2} = 23,5°$ und $\alpha_{2,3} = 23°$

Die hierdurch festgelegten Rasterfeinheiten sind zunächst wesentlich feiner als der in der Praxis geforderte Feinheitenbereich um 60 L/cm. Deshalb werden die Rasterperioden durch Multiplikation mit einem konstanten Faktor in den gewünschten Bereich umgerechnet. Dies entspricht praktisch einer Vergrößerung des Rastersystems mit einer Kamera. Durch die Umrechnung ergeben sich folgende Teilvarianten.

1): größte Rasterfeinheit 60 L/cm, Faktor 1,33

$d_1 = 0,193$ mm $= 51,7$ L/cm

$d_2 = 0,166$ mm $= 60,0$ L/cm

$d_3 = 0,200$ mm $= 50,0$ L/cm

2): mittlere Rasterfeinheit 60 L/cm, Faktor 1,15

$d_1 = 0,166$ mm $= 60,0$ L/cm

$d_2 = 0,144$ mm $= 69,4$ L/cm

$d_3 = 0,172$ mm $= 58,0$ L/cm

3): kleinste Rasterfeinheit 54 L/cm, Faktor 1,234568

$d_1 = 0,179$ mm $= 55,9$ L/cm

$d_2 = 0,154$ mm $= 64,8$ L/cm

$d_3 = 0,185$ mm $= 54,0$ L/cm

Das beste Resultat liefert die Variante 3, da sie die besten Eigenschaften für gute Verdruckbarkeit und gute Detailzeichnung erwarten läßt, wenn man den feinsten Raster für die Druckfarbe Schwarz nimmt.

Es werden nun noch die Winkellagen der Raster in bezug auf den 0°-Winkel angegeben, wozu insgesamt

**0 079 974**

folgendes Rastersystem für den 3-Farbendruck vorgeschlagen wird.

Rasterperiode Rasterfeinheit Winklung
1. Farbe 0,185 mm 54.05 L/cm 8°
2. Farbe 0,180 mm 55,56 L/cm 51,5°
3. Farbe 0,155 mm 64,52 L/cm 75°

In der Praxis wird in starkem Maße im 4-Farbendruck gearbeitet, d. h., es wird neben den drei Druckfarben Magenta, Cyan und Gelb noch die Druckfarbe Schwarz gedruckt, nachdem in der Regel bei den anderen drei Druckfarben eine Farbrücknahme durchgeführt wurde (UCR). Da die Druckfarbe, die im Druck mit dem geringsten Kontrast wiedergegeben wird, d. h. in der Regel Gelb, am wenigsten zur Moirébildung neigt bzw. das Moiré am wenigsten sichtbar ist, empfiehlt es sich, die Farbe Gelb als vierte Druckfarbe zu wählen und in das bereits vorgeschlagene Rastersystem einzufügen. Im vorliegenden Beispiel werden folgende Rasterwerte für die vierte Farbe vorgeschlagen.

Rasterperiode Winklung
1. Gelb 0,155 mm 62°
2. Gelb 0,155 mm 48,5°
3. Gelb 0,175 mm 27°

Als beste Ausführungsform erweist sich die Variante 3, da bei dieser Kombination durch die vierte Farbe, d. h. durch den Gelbraster, kein sichtbares Moiré erzeugt wird, wonach sich folgende Kombination als bestes Rastersystem für den Vier-Farbendruck ergibt.

Farbe Rasterperiode Rasterfeinheit Winklung
Cyan 0,185 mm 54,05 L/cm 8°
Magenta 0,180 mm 55,56 L/cm 51,5°
Gelb 0,175 mm 57,14 L/cm 27°
Schwarz 0,155 mm 64,52 L/cm 75°

Die Farbe-Raster-Zuordnung kann natürlich auch je nach Motiv der Vorlage geändert werden. Dies wird z. B. bei der konventionellen Winklung bei den Druckfarben Cyan, Magenta und Schwarz häufig angewendet.

Die gemäß der vorliegenden Erfindung vorgeschlagenen Rastersysteme weisen alle den Vorteil auf, daß sie relativ unanfällig gegen Verwinkelungen sind, was bei allen anderen Rastern bis auf die in der Dissertation von Schmidt vorgeschlagenen Raster, die aber in der Praxis unbrauchbar sind, nicht der Fall war. Bei dem bis ins Unendliche ausgewinkelten Moiré, z. B. bei dem Raster nach DIN-Winkelung, ist die hohe Genauigkeit von $\pm 1'$ bis $\pm 3'$ erforderlich, damit nicht mehr als ein Moiréfleck in einer Reproduktion auftritt. Bei der Übertragung der Druckvorlagen auf die Druckplatte, d. h. im eigentlichen Druckvorgang und durch ungleichmäßigen Papierverzug zwischen den einzelnen Druckvorgängen, treten aber Passerdifferenzen auf, die sich wie Winklungsfehler auswirken und leicht Werte annehmen, die größer sind als die vorgegebenen Genauigkeitsanforderungen. Bei der vorliegenden Erfindung können aber Abweichungen von der vorgeschriebenen Winkellage von 1° - 2° und von der Rasterperiode von $\pm 0,020$ mm bis 0,030 mm (bzw. allgemeiner ca. $\pm 15$ %) zugelassen werden, ohne daß es zur Moirébildung und einer sichtbaren Feinstruktur kommt, was im folgenden näher erläutert wird.

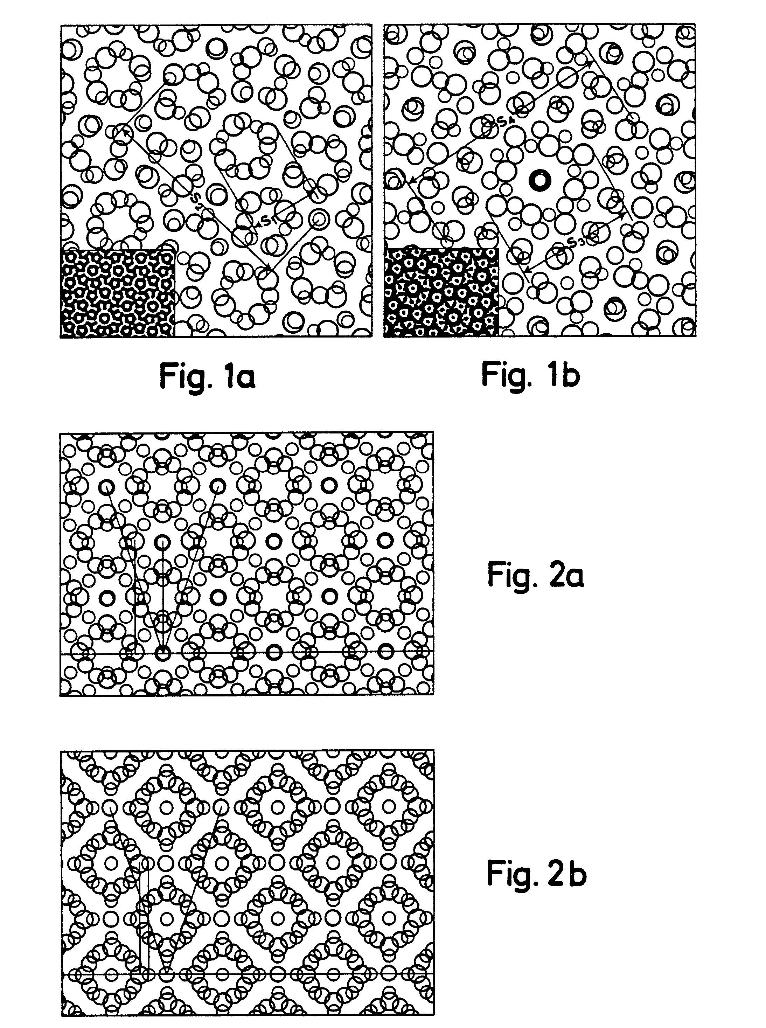

Es ist eine Eigenart bekannter Rastersysteme, daß im fertigen Druck sogenannte Rosettenmuster entstehen. Die Figuren 1a und 1b zeigen solche Feinstrukturen, wie sie z. B. bei der konventionellen Rasterung nach DIN 16547 auftreten. In Figur 1a sind die Rosetten ohne Mittelpunkte und in Fig. 1b mit Mittelpunkten dargestellt, wobei die Größe bzw. der Durchmesser der sich bildenden Punktemuster von der Rasterfeinheit abhängt. Es hat sich in der Praxis gezeigt, daß eine noch erträgliche, aber merkliche Feinstruktur sich bei einer Rasterfeinheit von etwa 60 L/cm ergibt. Gröbere Raster führen zu nicht mehr erträglicher Feinstruktur, wie dies auch bei dem in der Dissertation von Schmidt angegebenen Raster der Fall ist.

In Fig. 2a und 2b sind ebenfalls sich ergebende Punktmuster der Feinstruktur für die elektronische Rasterung gemäß den eingangs genannten Verfahren nach DE-B- 19 01 101, DE-C 20 12 728 und DE-C 21 07 738 angegeben. Hierbei ist in der Fig. 2b das Raster für die Farbe Schwarz um eine halbe Rastermaschendiagonale verschoben. In den Fig. 1a und 1b bzw. 2a und 2b sind die verwendeten Rasterwinkel als feine Striche dargestellt. Wie aus den Fig. 1a und 1b bzw. 2a und 2b hervorgeht, sind nach dem Druck in diesen Feinstrukturen unterschiedliche Überdeckungsverhältnisse der Rasterpunkte der einzelnen Raster anzutreffen. Dies ist die Ursache für Farbtonschwankungen, die auch als Farbspiel bezeichnet werden. In der Praxis hat es sich gezeigt, daß sowohl die konventionellen Rastersysteme der Fig. 1a und 1b als auch die elektronischen Rasterungssysteme gemäß Fig. 2a und 2b ein merkliches Farbspiel aufweisen, da die Überdeckungsflächen in den einzelnen Teilfarben beim Übereinanderdruck örtlich schwanken und sich entsprechend der Feinstruktur periodisch wiederholen, was die entsprechenden Figuren zeigen.

Rein theoretisch könnte dieses Farbspiel vermieden werden, wenn man eine Punktverteilung wählen würde, die den Formeln von Neugebauer (Dissertation 1935) genügt, weil dort eine statistische Wahrscheinlichkeit für die Berechnung der Überdeckungsflächen der einzelnen Teilfarben beim Übereinanderdruck unterstellt wurde.

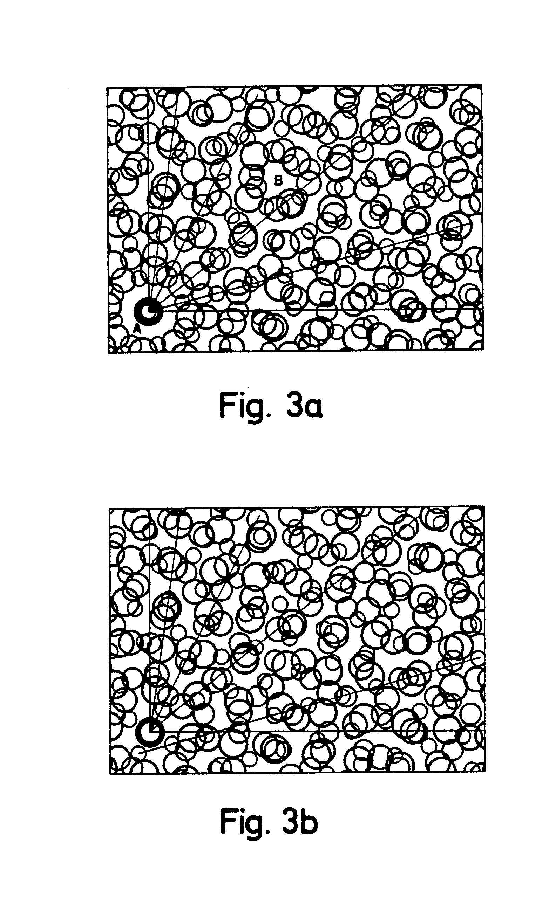

Wie die Fig. 1a und 1b sowie 2a und 2b zeigen, ist es aber nicht gelungen, bisher Rastersysteme anzugeben, die diese Forderung erfüllen. Die Fig. 3a und 3b zeigen aber, daß es gemäß der vorliegenden Erfindung möglich ist, daß bei den angegebenen Rasterstrukturen bezüglich des Farbspiels wesentlich günstigere Verhältnisse erreicht werden, wobei sich gezeigt hat, daß die mittleren Tonwertfehler bis auf $\pm 0,2$ % mit den Berechnungen nach den Formeln von Neugebauer übereinstimmen. Der Vergleich der Figuren zeigt also, daß bei den erfindungsgemäßen Rastersystemen die Feinstruktur eine viel geringere Regelmäßigkeit aufweist. Das

4

bedeutet gleichzeitig, daß das Aufeinandertreffen der Rasterpunkte der einzelnen Raster wesentlich mehr zufallsbedingte Feinstrukturen aufweist und damit farbspielunabhängiger ist, da der vorhandene Resteffekt weit unter dem Wahrnehmungsvermögen des menschlichen Auges liegt.

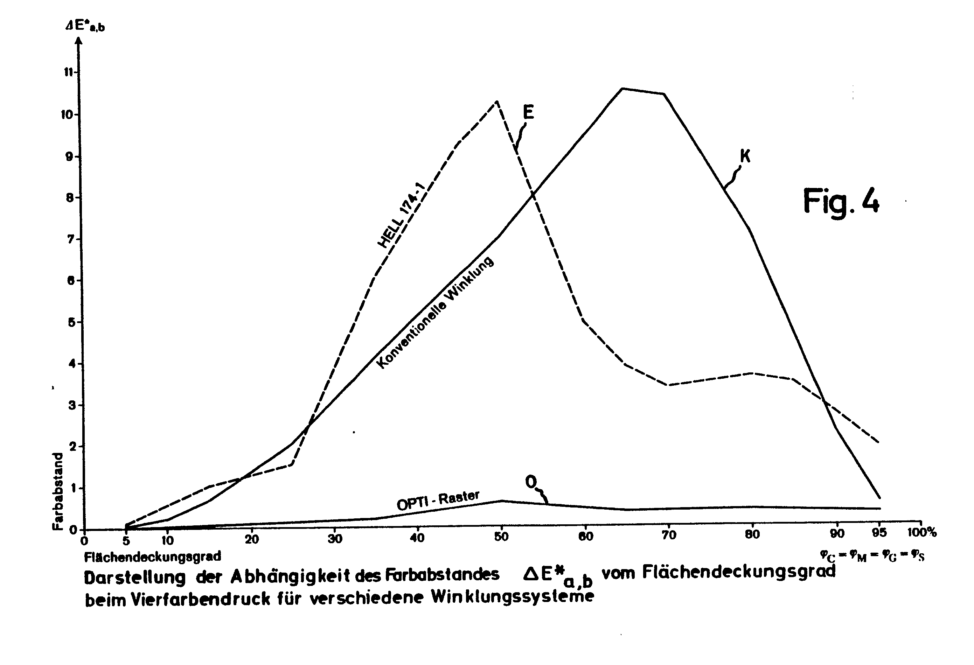

Fig. 4 zeigt eine grafische Darstellung, die eine Gegenüberstellung des sich aus dem möglichen Farbspiel ergebenden Farbabstandes in Abhängigkeit vom Flächenbedeckungsgrad für das konventionelle Rastersystem K gemäß der vorgenannten DIN-Norm, das elektronische Rastersystem E und das erfindungsgemäße Rastersystem 0 zeigt. Die Farbtonschwankung kann z. B. durch die Verschiebung des Schwarzrasters um eine halbe Rastermaschendiagonale erzeugt werden. Wie man leicht erkennen kann, bringt das erfindungsgemäße Rastersystem über den Bereich des Flächenbedeckungsgrades von 5 % bis 95 % einen wesentlich geringeren Farbabstand.

Es sei noch erwähnt, daß die Rastersysteme der vorliegenden Erfindung in der Praxis in mehrfacher Form zur Anwendung kommen können, sei es als sog. Kopier- oder Kontaktraster beim Erstellen von Druckformen für die verschiedenen Druckverfahren, in Form einer elektronischen Rasterung bei der elektronischen Farbauszugsherstellung oder in einer beliebigen anderen Form, in der solche Rastersysteme für die Farbbildreproduktion verwendet werden können.

## Patentansprüche

1. Rastersysteme für die Farbreproduktion bei denen in den einzelnen Farbauszügen jeweils Raster verwendet werden, deren Winkelungen und Rasterfeinheiten bzw. die sich aus den Rasterfeinheiten ergebenden Rasterperioden von Farbauszug zu Farbauszug verschieden sind, dadurch gekennzeichnet, daß Rastersysteme verwendet werden, deren Raster folgende Rasterperioden aufweisen:.

$d_1 = 0,185$ $d_2 = 0,125$ $d_3 = 0,185$
$d_1 = 0,160$ $d_2 = 0,135$ $d_3 = 0,155$
$d_1 = 0,155$ $d_2 = 0,135$ $d_3 = 0,185$
$d_1 = 0,155$ $d_2 = 0,130$ $d_3 = 0,170$
$d_1 = 0,155$ $d_2 = 0,130$ $d_3 = 0,150$
$d_1 = 0,145$ $d_2 = 0,160$ $d_3 = 0,170$
$d_1 = 0,145$ $d_2 = 0,125$ $d_3 = 0,150$
$d_1 = 0,145$ $d_2 = 0,125$ $d_3 = 0,170$
$d_1 = 0,140$ $d_2 = 0,155$ $d_3 = 0,165$
wobei
$d_1$ die Rasterperiode des ersten Rasters,
$d_2$ die Rasterperiode des Zweiten Rasters und
$d_3$ die Rasterperiode des dritten Rasters sind,
und wobei
die Rasterfeinheiten in Linien/cm die Reziprokzahl der Rasterperioden in cm ist und wobei
der Toleranzbereich für die Rasterfeinheiten um etwa $\pm 12$ % um die mittlere Rasterfeinheit liegt und die Winkeltoleranzen für die Winkel zwischen den einzelnen Rastern in den Bereichen zwischen 19° - 24° oder 25° - 29° oder 32° - 36° liegen.

2. Rastersystem für die Farbreproduktion, bei dem in den einzelnen Farbauszügen jeweils Raster verwendet werden, deren Winkelungen und Rasterfeinheiten bzw. die sich aus den Rasterfeinheiten ergebenden Rasterperioden von Farbauszug zu Farbauszug verschieden sind, dadurch gekennzeichnet, daß ein Rastersystem verwendet wird, dessen Raster folgende Rasterperioden aufweisen:

$d_1 = 0,145$ $d_2 = 0,130$ $d_3 = 0,175$ bis $0,180$
wobei
$d_1$ die Rasterperiode des ersten Rasters,
$d_2$ die Rasterperiode des zweiten Rasters und
$d_3$ die Rasterperiode des dritten Rasters ist,
und wobei
die Rasterfeinheiten in Linien/cm die Reziprokzahl der Rasterperioden in cm ist und wobei
der Toleranzbereich für die Rasterfeinheit um etwa $\pm 12$ % um die mittlere Rasterfeinheit liegt und die Winkeltoleranzen für die Winkel zwischen den einzelnen Rastern in den Bereichen zwischen 27° - 29° und 31° - 35° liegen.

3. Rastersystem für die Farbreproduktion, bei dem in den einzelnen Farbauszügen jeweils Raster verwendet werden, deren Winkelungen und Rasterfeinheiten bzw. die sich aus den Rasterfeinheiten ergebenden Rasterperioden von Farbauszug zu Farbauszug verschieden sind, dadurch gekennzeichnet, daß ein Rastersystem verwendet wird, dessen Raster folgende Rasterperioden aufweisen:

$d_1 = 0,140$ $d_2 = 0,125$ $d_3 = 0,175$
wobei
$d_1$ die Rasterperiode des ersten Rasters,
$d_2$ die Rasterperiode des zweiten Rasters und
$d_3$ die Rasterperiode des dritten Rasters sind,

und wobei

die Rasterfeinheit in Linien/cm die Reziprokzahl der Rasterperioden in cm ist und wobei

der Toleranzbereich für die Rasterfeinheiten um $\pm 12\,\%$ um die mittlere Rasterfeinheit liegt und die Winkeltoleranzen für die Winkel zwischen den einzelnen Rastern in den Bereichen zwischen 27° - 31° und 32° - 35° liegen.

4. Rastersystem für die Farbreproduktion, bei dem in den einzelnen Farbauszügen jeweils Raster verwendet werden, deren Winkelungen und Rasterfeinheiten bzw. die sich aus den Rasterfeinheiten ergebenden Rasterperioden von Farbauszug zu Farbauszug verschieden sind, dadurch gekennzeichnet, daß ein Rastersystem verwendet wird, dessen Raster folgende Rasterperioden aufweisen:

$d_1 = 0{,}140$  $d_2 = 0{,}125$  $d_3 = 0{,}150$

wobei

$d_1$ die Rasterperiode des ersten Rasters,

$d_2$ die Rasterperiode des zweiten Rasters und

$d_3$ die Rasterperiode des dritten Rasters sind,

und wobei

die Rasterfeinheit in Linien/cm die Reziprokzahl der Rasterperioden in cm ist und wobei

der Toleranzbereich für die Rasterfeinheiten um etwa $\pm 12\,\%$ um die mittlere Rasterfeinheit liegt und die Winkeltoleranzen für die Winkel zwischen den einzelnen Rastern in den Bereichen zwischen 25° - 27° und 22° - 25° liegen.

5. Rastersystem für die Farbreproduktion, bei dem in den einzelnen Farbauszügen jeweils Raster verwendet werden, deren Winkelungen und Rasterfeinheiten bzw. die sich aus den Rasterfeinheiten ergebenden Rasterperioden von Farbauszug zu Farbauszug verschieden sind, dadurch gekennzeichnet, daß ein Rastersystem verwendet wird, dessen Raster folgende Rasterperioden aufweist:

$d_1 = 0{,}125$  $d_2 = 0{,}130$  $d_3 = 0{,}150$

wobei

$d_1$ die Rasterperiode des ersten Rasters,

$d_2$ die Rasterperiode des zweiten Rasters und

$d_3$ die Rasterperiode des dritten Rasters sind,

und wobei

die Rasterfeinheit in Linien/cm die Reziprokzahl der Rasterperiode in cm ist und wobei

der Toleranzbereich für die Rasterfeinheiten um etwa $\pm 12\,\%$ um die mittlere Rasterfeinheit liegt und die Winkeltoleranzen für die Winkel zwischen den einzelnen Rastern in den Bereichén zwischen 20° - 26° und 25° - 29° liegen.

6. Rastersystem für die Farbreproduktion, bei dem in den einzelnen Farbauszügen jeweils Raster verwendet werden, deren Winkelungen und Rasterfeinheiten von Farbauszug zu Farbauszug verschieden sind, dadurch gekennzeichnet, daß das Raster einer Farbe eine Feinheit von 54,0 L/cm und eine Winkelung von 8° gegen die 0°-Richtung, das zweite Raster für die zweite Farbe eine Rasterfeinheit von 55,56 L/cm und eine Winkelung von 51,5° gegen die 0°-Richtung und das dritte Raster eine Rasterfeinheit von 64,52 L/cm und eine Winkelung von 75° gegen die 0°-Richtung aufweist, wobei der Winkeltoleranzbereich etwa 1° - 2º ist und der Toleranzbereich der Rasterfeinheit bei etwa $\pm 12\,\%$ liegt.

7. Rastersystem für den Vierfarbendruck nach Anspruch 6, dadurch gekennzeichnet, daß ein viertes Raster verwendet wird, das eine Rasterfeinheit von 64,52 L/cm und eine Winkelung von 62° gegen die 0°-Lage oder eine Rasterfeinheit von 64,52 L/cm und eine Winkelung von 48,5° gegen die 0°-Lage oder eine Rasterfeinheit von 57,14 L/cm und eine Winkelung von 27° gegen die 0°-Lage aufweist, wobei der Winkeltoleranzbereich etwa 1° - 2° ist und der Toleranzbereich der Rasterfeinheit bei etwa $\pm 12\,\%$ liegt.

8. Rastersystem für den Vierfarbendruck nach Anspruch 7, dadurch gekennzeichnet, daß ein Raster eine Rasterfeinheit von 54,05 L/cm und einen Winkel von 8°, ein Raster eine Rasterfeinheit von 55,56 L/cm und einen Winkel von 51,5°, ein Raster eine Feinheit von 57,14 L/cm und einen Winkel von 27° und ein Raster eine Rasterfeinheit von 64,52 L/cm und einen Winkel von 75° aufweist, wobei die Winkel gegen die 0°-Richtung gemessen sind und der Winkeltoleranzbereich etwa 1° - 2° ist und die Rasterfeinheit in einem Toleranzbereich von etwa $\pm 12\,\%$ liegen.

9. Rastersystem nach einem der Ansprüche 1 - 8, dadurch gekennzeichnet, daß weitere Rastersysteme durch Umrechnung der Rasterfeinheiten mit einem konstanten Faktor gewonnen werden.

10. Rastersystem, nach einem der Ansprüche 1 - 9, dadurch gekennzeichnet, daß weitere Rastersysteme durch Verdrehung aus einem der Rastersysteme der Ansprüche 1 - 9 gewonnen werden.

11. Rastersystem nach einem der Ansprüche 1 - 10, dadurch gekennzeichnet, daß weitere Rastersysteme durch Spiegelung aus einem der Rastersysteme gemäß dén Ansprüchen 1-10 gewonnen werden.

12. Rasterungsystem nach einem der Ansprüche 1 - 11, dadurch gekennzeichnet, daß z. B. für elliptische Rasterpunktformen mindestens ein Rasterwinkel um $\pm 90\,\%$ verdreht wird.

## 0 079 974

**Claims**

1. Screen system for colour reproduction in which screens are utilized in each case in the individual colour separations, of which the angles and screen line spacings, or the screen periods resulting from the screen line spacings, differ from colour separation to colour separation, characterized in that screen system are utilized whose screens have the following screen periods:

$d_1 = 0.185\ d_2 = 0.125\ d_3 = 0.185$
$d_1 = 0.160\ d_2 = 0.135\ d_3 = 0.155$
$d_1 = 0.155\ d_2 = 0.135\ d_3 = 0.185$
$d_1 = 0.155\ d_2 = 0.130\ d_3 = 0.170$
$d_1 = 0.155\ d_2 = 0.130\ d_3 = 0.150$
$d_1 = 0.145\ d_2 = 0.160\ d_3 = 0.170$
$d_1 = 0.145\ d_2 = 0.125\ d_3 = 0.150$
$d_1 = 0.145\ d_2 = 0.125\ d_3 = 0.170$
$d_1 = 0.140\ d_2 = 0.155\ d_3 = 0.165$

wherein
$d_1$ is the screen period of the first screen,
$d_2$ is the screen period of the second screen and
$d_3$ is the screen period of the third screen, and wherein the screen line spacings in lines/cm are the reciprocals of the screen periods in cms, and for which purpose the tolerance range for the screen line spacing extends to approximately plus or minus 12 % around the mean screen line spacing, and the angular tolerances for the angles between the individual screens lie within the ranges between 19° and 24°, 25° and 29° or 32° and 36°.

2. Screen system for colour reproduction in which screens are utilized in each case in the individual colour separations, of which the angles and screen line spacings, or the screen periods resulting from the screen line spacings, differ from colour separation to colour separation, characterized in that screen system is utilized whose screens have the following screen periods:

$d_1 = 0.145\ d_2 = 0.130\ d_3 = 0.175$ to $0.180$ wherein
$d_1$ is the screen period of the first screen,
$d_2$ is the screen period of the second screen and
$d_3$ is the screen period of the third screen, and wherein the screen line spacings in lines/cm are the reciprocals of the screen periods in cms, and for which purpose the tolerance range for the screen line spacing extends to approximately plus or minus 12 % around the mean screen lines spacing, and the angular tolerances for the angles between the individual screens lie within the ranges between 27° and 29° and between 31° and 35°.

3. Screen system for colour reproduction in which screens are utilized in each case in the individual colour separations, of which the angles and screen lines spacings, or the screen periods resulting from the screen line spacings, differ from colour separation to colour separation, characterized in that use is made of a screen system whose screens have the following screen periods:

$d_1 = 0.140\ d_2 = 0.125\ d_3 = 0.175$
wherein
$d_1$ is the screen period of the first screen,
$d_2$ is the screen period of the second screen and
$d_3$ is the screen period of the third screen, and for which purpose the tolerance range for the screen line spacing extends to approximately plus or minus 12 % around the mean screen line spacing, and the angular tolerances for the angles between the individual screens lie within the ranges between 27° to 31° and between 32° to 35°.

4. Screen system for colour reproduction in which screens are utilized in each case in the individual colour separations, of which the angles and screen line spacings, or the screen periods resulting from the screen line spacings, differ from colour separation to colour separation, characterized in that use is made of a screensystem whose screens have the following screen periods:

$d_1 = 0.140\ d_2 = 0.125$ and $d_3 = 0.150$
wherein
$d_1$ is the screen period of the first screen,
$d_2$ is the screen period of the second screen and
$d_3$ is the screen period of the third screen,
and for which purpose
the tolerance range for the screen line spacing extends to approximately plus of minus 12 % around the mean screen line spacing, and the angular tolerances for the angles between the individual screens lie within the ranges between 25° to 27° and between 22° to 25°.

5. Screen system for colour reproduction in which screens are utilized in each case in the individual colour separations, of which the angles and screen line spacings, or the screen periods resulting from the screen line spacings, differ from colour separation to colour separation, characterized in that use is made of a screen system whose screens have the following screen periods:

$d_1 = 0.125\ d_2 = 0.130\ d_3 = 0.150$

7

wherein

$d_1$ is the screen period of the first screen,

$d_2$ is the screen period of the second screen and

$d_3$ is the screen period of the third screen,

and for which purpose

the tolerance range for the screen line spacing extends to approximately plus or minus 12 % around the mean screen line spacing, and the angular tolerances for the angles between the individual screens lie within the ranges between 20° to 26° and between 25° to 29°.

6. Screen system for colour reproduction, in which screens are utilized in each case in the individual colour separations of which the angles and screen line spacings differ from colour separation to colour separation, characterized in that the screen of one colour has a line spacing of 54.0 lines/cm and an angle of 8° with respect to the 0° direction, that the second screen for the second colour has a screen line spacing of 55.56 lines/cm and an angle of 51.5° with respect to the 0° direction, and the third screen has a screen line spacing of 64.52 lines/cm and an angle of 75° with respect to the 0° direction, the ranges of angular tolerance being approximately 1° and 2° and the tolerance range for the screen line spacing amounts to approximately plus or minus 12 %.

7. Screen system for four-colour printing according to claim 6, characterized in the use is made of a fourth screen which has a screen line spacing of 64.52 lines/cm and an angle of 62° with respect to the 0° setting, or a screen line spacing of 64.52 lines/cm and an angle of 48.5° with respect to the 0° setting, or a screen line spacing of 57.14 lines/cm and an angle of 27° with respect to the 0° setting, the range of angular tolerance being approximately 1° to 2° and the tolerance range for the screen line spacing lying at approximately plus or minus 12 %.

8. Screen system for four-colour printing according to claim 7, characterized in that one screen has a screen line spacing of 54.05 lines/cm and an angle of 8°, one screen has a screen line spacing of 55.56 lines/cm and an angle of 51.5°, one screen has a line spacing of 57.14 lines/cm and an angle of 27° and one screen has a screen line spacing of 64.52 lines/cm and an angle of 75°, wherein the angles are measured with respect to the 0° direction and the range of angular tolerance is approximately 1° to 2° and the screen line spacings line within a tolerance range of approximately plus or minus 12 %.

9. Screen system according to one of the claims 1 to 8, characterized in that other screen systems are obtained by recalculation of the screen line spacings based on a constant factor.

10. Screen system according to one of the claim 1 to 9, characterized in that other screen systems are obtained by rotational displacement from one of the screen systems of claims 1 to 9.

11. Screen system according to one of the claim 1 to 10, characterized in that other screen systems are obtained by reflection from one of the screen systems according to claims 1 to 10.

12. Screening system according to one of the claims 1 to 11, characterized in that at least one screen angle is rotated through plus or minus 90°, e.g. for elliptical screen dot or half-tone dot shapes.


**Revendications**

1°) Systèmes de trames pour la reproduction en couleurs, dans lesquels on utilise pour les extraits de couleur individuels des trames respectives dont les angles d'orientation et les finesses ou les périodes de trame engendrées par les finesses de trame diffèrent d'extrait de couleur à extrait de couleur, caractérisés en ce que l'on utilise des systèmes de trames dont les trames présentent les périodes de trame suivantes:

$d_1 = 0,185 \ d_2 = 0,125 \ d_3 = 0,185$

$d_1 = 0,160 \ d_2 = 0,135 \ d_3 = 0,155$

$d_1 = 0,155 \ d_2 = 0,135 \ d_3 = 0,185$

$d_1 = 0,155 \ d_2 = 0,130 \ d_3 = 0,170$

$d_1 = 0,155 \ d_2 = 0,130 \ d_3 = 0,150$

$d_1 = 0,145 \ d_2 = 0,160 \ d_3 = 0,170$

$d_1 = 0,145 \ d_2 = 0,125 \ d_3 = 0,150$

$d_1 = 0,145 \ d_2 = 0,125 \ d_3 = 0,170$

$d_1 = 0,140 \ d_2 = 0,155 \ d_3 = 0,165$

$d_1$ étant la période de trame de la première trame,

$d_2$ étant la période de trame de la deuxième trame, et

$d_3$ étant la période de trame de la troisième trame,

et

les finesses des trames, en lignes/cm, étant la réciproque des périodes de trame en cm, et

la marge de tolérance des finesses des trames étant d'environ ± 12 % de la finesse de trame moyenne et les tolérances d'angle des angles entre les différentes trames étant situées dans les intervalles compris entre 19° - 24° ou 25° - 29° ou 32° - 36°.

2°) Systèmes de trames pour la reproduction en couleurs dans lesquels on utilise pour les extraits de couleur individuels des trames respectives dont les angles d'orientation et les finesses ou les périodes de trame engendrées par les finesses de trame diffèrent d'extrait de couleur à extrait de couleur, caractérisés en ce que

# 0 079 974

l'on utilise des systèmes de trames dont les trames présentent les périodes de trame suivantes:

$d_1 = 0,145$ $d_2 = 0,130$ $d_3 = 0,175$ à $0,180$

$d_1$ étant la période de trame de la première trame,

$d_2$ étant la période de trame de la deuxième trame, et

$d_3$ étant la période de trame de la troisième trame,

et

les finesses des trames, en lignes/cm, étant la réciproque des périodes de trame en cm, et

la marge de tolérance des finesses des trames étant d'environ $\pm 12$ % de la finesse de trame moyenne et les tolérances d'angle des angles entre les différentes trames étant situées dans les intervalles compris entre 27° - 29° et 31° - 35°.

3°) Systèmes de trames pour la reproduction en couleurs, dans lesquels on utilise pour les extraits de couleur individuels des trames respectives dont les angles d'orientation et les finesses ou les périodes de trame engendrées par le finesse de trame diffèrent d'extrait de couleur à extrait de couleur, caractérisés en ce que l'on utilise des systèmes de trames dont les trames présentent les périodes de trame suivantes:

$d_1 = 0,140$ $d_2 = 0,125$ $d_3 = 0,175$

$d_1$ étant la période de trame de la première trame,

$d_2$ étant la période de trame de la deuxième trame, et

$d_3$ étant la période de trame de la troisième trame

et

les finesses des trames, en lignes/cm, étant la réciproque des périodes de trame en cm, et

la marge de tolérance des finesses des trames étant d'environ $\pm 12$ % de la finesse de trame moyenne et les tolérances d'angle des angles entre les différentes trames étant situées dans les intervalles compris entre 27° - 31° et 32° - 35°.

4°) Systèmes de trames pour la reproduction en couleurs, dans lesquels on utilise pour les extraits de couleur individuels des trames respectives dont les angles d'orientation et les finesses ou les périodes de trame engendrées par les finesses de trame diffèrent d'extrait de couleur à extrait de couleur, caractérisés en ce que l'on utilise des systèmes de trames dont les trames présentent les périodes de trame suivantes:

$d_1 = 0,140$ $d_2 = 0,125$ $d_3 = 0,150$

$d_1$ étant la période de trame de la première trame,

$d_2$ étant la période de trame de la deuxième trame, et

$d_3$ étant la période de trame de la troisième trame

et

les finesses des trames, en lignes/cm, étant la réciproque des periodes de trame en cm, et

la marge de tolérance des finesses des trames étant d'environ $\pm 12$ % de la finesse de trame moyenne et les tolérances d'angle des angles entre les différentes trames étant situées dans les intervalles compris entre 25° - 27° et 22° - 25°.

5°) Systèmes de trames pour la reproduction en couleurs, dans lesquels on utilise pour les extraits de couleur individuels des trames respectives dont les angles d'orientation et les finesses ou les périodes de trame engendrées par les finesses de trame diffèrent d'extrait de couleur à extrait de couleur, caractérisés en ce que l'on utilise des systèmes de trames dont les trames présentent les périodes de trame suivantes:

$d_1 = 0,125$ $d_2 = 0,130$ $d_3 = 0,150$

$d_1$ étant la période de trame de la première trame,

$d_2$ étant la période de trame de la deuxième trame, et

$d_3$ étant la période de trame de la troisième trame

et

les finesses des trames, en lignes/cm, étant la réciproque des périodes de trame en cm, et

la marge de tolérance des finesses des trames étant d'environ $\pm 12$ % de la finesse de trame moyenne et les tolérances d'angle des angles entre les différentes trames étant situées dans les intervalles compris entre 20° - 26° et 25° - 29°.

6°) Système de trames pour la reproduction en couleurs, dans lequel on utilise pour les extraits de couleur individuels des trames respectives dont les angles d'orientation et les finesses de trame diffèrent d'extrait de couleur à ertrait de couleur, caractérisé en ce que la trame d'une couleur présente une finesse de 54,0 L/cm et un angle d'orientation de 8° par rapport à la direction 0°, la deuxième trame pour la deuxième couleur présente une finesse de 55,56 L/cm et un angle d'orientation de 51,5° par rapport à la direction 0°, et la troisième trame présente une finesse de 64,52 L/cm et un angle d'orientation de 75° par rapport à la direction 0°, la marge de tolérance d'angle étant d'environ 1° - 2° et la marge de tolérance de la finesse de trame étant d'environ $\pm 12$%.

7°) Système de trames pour l'impression en quadrichromie selon la revendication 6, caractérisé en ce que l'on utilise une quatrième trame qui présente une finesse de 64,52 L/cm et un angle d'orientation de 62° par rapport à la position 0°, ou une finesse de 64,52 L/cm et un angle d'orientation de 48,5° par rapport à la position 0°, ou une finesse de 57,14 L/cm et un angle d'orientation de 27° par rapport à la position 0°, la marge de tolérance d'angle étant d'environ 1° - 2° et la marge de tolérance de la finesse de trame étant d'environ $\pm 12$ %.

8°) Système de trames pour l'impression en quadrichromie selon la revendication 7, caractérisé par le fait qu'une trame présente une finesse de 54,05 L/cm et un angle de 8°, une trame présente une finesse de 55,56 L/cm et un angle de 51,5°, une trame présente une finesse de 57,14 L/cm et un angle de 27°, et une trame

9

**0 079 974**

présente une finesse de 664,52 L/cm et un angle de 75°, les angles étant mesurés par rapport à la direction 0° et la marge de tolérance des angles étant d'environ 1° - 2°, et la finesse de trame étant située dans une marge de tolérance d'environ $\pm$ 12%.

9°) Système de trames selon l'une quelconque des revendications 1 à 8, caractérisé en ce que l'on obtient d'autres systèmes de trames par conversion des finesses de trames au moyen d'un facteur constant.

10°) Système de trames selon l'une quelconque des revendications 1 à 9, caractérisé en ce que l'on obtient d'autres systèmes de trames par déplacement angulaire à partir d'un des systèmes de trames des revendications 1 à 9.

11°) Système de trames selon l'une quelconque des revendications 1 à 10, caractérisé en ce que l'on obtient d'autres sysèmes de trames par inversion à partir d'un des systèmes de trames selon les revendications 1 à 10.

12°) Système de tramage selon l'une quelconque des revendications 1 à 11, caractérisé en ce que l'on effectue, par exemple pour des formes elliptiques de points de trames, au moins un déplacement d'un angle de trame de $\pm$ 90°.

Fig. 1a

Fig. 1b

Fig. 2a

Fig. 2b

Fig. 3a

Fig. 3b

Fig. 4

$\varphi_C = \varphi_M = \varphi_G = \varphi_S$

Flächendeckungsgrad

$\Delta E^*_{a,b}$

Farbabstand

K

E

HELL 174-1

Konventionelle Winklung

OPTI - Raster

O

Flächendeckungsgrad

Darstellung der Abhängigkeit des Farbabstandes $\Delta E^*_{a,b}$ vom Flächendeckungsgrad beim Vierfarbendruck für verschiedene Winklungssysteme